# EUROPEAN PATENT APPLICATION

(11) **EP 3 795 714 A1**
(43) Date of publication of application: **24.03.2021**
(21) Application number: 19197689.3
(22) Date of filing: 17.09.2019
(51) Int. Cl.: C23C 16/20, C01B 6/06, C23C 16/44, C23C 16/455

(54) **PROCESS FOR THE GENERATION OF ALUMINUM-CONTAINING FILMS**

(71) Applicant: BASF SE, 67056 Ludwigshafen am Rhein (DE); The Regents of the University of California, Oakland, CA 94607-5200 (US)
(72) Inventor: Kummel, Andrew, Oakland, CA 94607-5200 (US); Wolf, Steven, Oakland, CA 94607-5200 (US); Breeden, Michael, Oakland, CA 94607-5200 (US); Ueda, schott T., Oakland, CA 94607-5200 (US); McLeod, Aaron, Oakland, CA 94607-5200 (US); Mayr, Lukas, 67056 Ludwigshafen (DE); Hufnagel, Alexander Georg, 67056 Ludwigshafen (DE); Loeffler, Daniel Dr., 67056 Ludwigshafen (DE); Wilmer, Hagen Dr., 67056 Ludwigshafen (DE)
(74) Representative: BASF IP Association

(57) **Abstract**

The present invention is in the field of processes for preparing an aluminum-containing film comprising bringing a solid substrate in contact with an aluminum hydride derivative in the gaseous state while the partial vapor pressure of an aluminum halide is 0.001 to 5 mbar.

## Description

The present invention is in the field of processes for the generation of thin aluminum-containing films on substrates, in particular atomic layer deposition processes.

With the ongoing miniaturization, e.g. in the semiconductor industry, the need for thin metal-containing films on substrates increases while the requirements on the quality of such films become stricter. Thin metal-containing films serve different purposes such as barrier layers, conducting features, or capping layers. Semiconductor products, for example computer chips, have a sophisticated architecture including different materials. One important material is aluminum. For very thin aluminum films, it is difficult to deposit uniform films due to slow nucleation. This leads to undesired island formation, so the films do not serve their purpose, such as conducting electric current.

US 8 013 401 discloses a CVD process employing an alane to deposit aluminum layers. However, very thin homogeneous aluminum films can hardly be obtained.

WO 2013 / 070 702 A1 discloses a process for depositing metal films employing aluminum hydride which is coordinated by a diamine as reducing agent. Again, very thin homogeneous aluminum films can hardly be obtained.

It was therefore an object of the present invention to provide a process for depositing aluminum-containing films on a substrate being uniform at thicknesses of only a few nanometers. It was aimed at a process which is easy and can be applied to a broad range of substrate materials. The process shall yield films of high quality with a high degree of reproducibility.

These objects were achieved by a process for preparing an aluminum-containing film comprising bringing a solid substrate in contact with an aluminum hydride derivative in the gaseous state while the partial vapor pressure of an aluminum halide is 0.001 to 5 mbar.

Preferred embodiments of the present invention can be found in the description and the claims. Combinations of different embodiments fall within the scope of the present invention.

According to the present invention a solid substrate is brought in contact with an aluminum hydride derivative. The solid substrate can be any solid material. These include for example metals, semimetals, oxides, nitrides, and polymers. Preferred materials are Ru, Rh, Pd, Ag, Os, Ir, Pt, Au, Si, Ti, Co, Ni, Cu, Ge, Mo, Ta, W, hydrogen-terminated Si, oxides, nitrides, carbides of Si, Ti, Co, Ni, Cu, Ge, Mo, Ta or W, or alkyl-terminated silicon, such as methyl terminated silicon. It is also possible that the substrate is a mixture of different materials. Examples for metals are aluminum, steel, zinc, and copper. Examples for semimetals are silicon, germanium, and gallium arsenide. Examples for oxides are silicon dioxide, titanium dioxide, and zinc oxide. Examples for nitrides are silicon nitride, aluminum nitride, titanium nitride, tantalum nitride, and gallium nitride. Examples for polymers are polyethylene terephthalate (PET), polyethylene naphthalene-dicarboxylic acid (PEN), and polyamides.

The solid substrate can have any shape. These include wafers, sheet plates, films, fibers, particles of various sizes, and substrates with trenches or other indentations. The solid substrate can be of any size. If the solid substrate has a particle shape, the size of particles can range from below 100 nm to several centimeters, preferably from 1 µm to 1 mm. In order to avoid particles or fibers to stick to each other while the aluminum-containing compound is deposited onto them, it is preferably to keep them in motion. This can, for example, be achieved by stirring, by rotating drums, or by fluidized bed techniques.

An aluminum hydride derivative in the context of the present invention is any compound which contains at least one Al-H bond. Preferably, the aluminum hydride derivative contains aluminum, which is bond only to hydrogen and one or more of oxygen, nitrogen or carbon. Aluminum hydride derivatives include alkyl aluminum hydrides, amine coordinated aluminum hydrides, and carbene coordinated aluminum hydrides.

Alkyl aluminum hydrides include dimethyl aluminum hydride and dibutyl aluminum hydride.

Amine coordinated aluminum hydrides include aluminum hydrides which are coordinated by an amine via one nitrogen atom, aluminum hydrides which are coordinated by an amine via two nitrogen atoms and aluminum hydrides which are coordinated by an amine via three nitrogen atoms.

Preferred examples for an aluminum hydride which are coordinated by an amine via one nitrogen atom is trialkylamine alane such as trimethylamine alane, dimethylethylamine alane, triethylamine alane, and N-methylpyrrolidine alane.

Preferably, the aluminum hydride derivative is a compound of general formula (Ia) or (Ib) 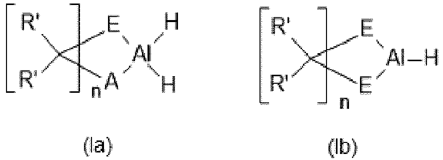
wherein A is NR₂ or OR with R being an alkyl group, an alkenyl group, an aryl group, or a silyl group,
E is NR or O,
n is 0, 1 or 2, m is 0, 1 or 2, and
R' is hydrogen, an alkyl group, an alkenyl group, an aryl group, or a silyl group.

More preferably, the aluminum hydride derivative is a compound of general formula (Ia1)

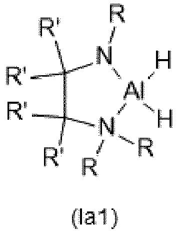

Preferably, R' are hydrogen. Preferably, R are alkyl groups, in particular R in NR is tert-butyl and R in NR₂ are methyl.

Another preferred example for an aluminum hydride which are coordinated by an amine via two nitrogen atoms is the compound of general formula (II) 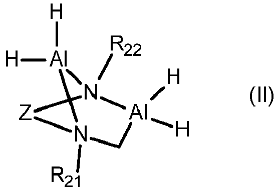
wherein Z is a C₂-C₄ alkylene group, and
R is hydrogen, an alkyl group, an alkenyl group, an aryl group, or a silyl group.

Z in the compound of general formula (II) is a C₂-C₄ alkylene group including ethylene, i.e. -CH₂-CH₂-, 1,3-propylene, i.e. -CH₂-CH₂-CH₂-, and 1,4-butylene, i.e. -CH₂-CH₂-CH₂-CH₂-, preferably ethylene. The alkylene group can be substituted by halogens, alkyl groups, alkenyl groups, aryl groups or silyl groups as described above.

The compound of general formula (II) can be synthesized by heating a N-heterocyclic carbene with two equivalents of an aluminum hydride complex, for example aluminum hydride coordinated by trimethylamine. The synthesis of various N-heterocyclic carbenes is well known from the prior art. The following equation shows the synthesis.

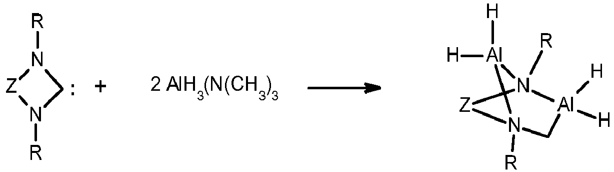

The reaction can be done in a solvent of low polarity, for example aromatic hydrocarbons such as toluene. The reaction temperature is typically 25 to 150 °C, preferably 60 to 120 °C, the reaction time is typically 10 min to 2 h, preferably 20 to 40 min.

Another preferred example for aluminum hydride derivatives are the compounds of general formula (IIIa), (IIIb), (IIIc) and (IIId) 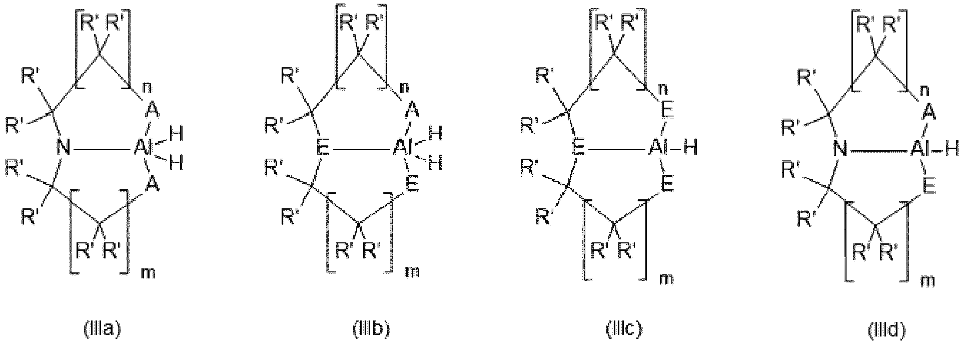
wherein A is NR₂ or OR with R being an alkyl group, an alkenyl group, an aryl group, or a silyl group,
E is NR or O,
n is 0, 1 or 2, m is 0, 1 or 2, and
R' is hydrogen, an alkyl group, an alkenyl group, an aryl group, or a silyl group.

A preferred example for an aluminum hydride which are coordinated by an amine via three nitrogen atoms is the compound of general formula (III)

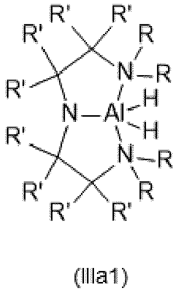

Preferably, R' are hydrogen.

A preferred example for carbene coordinated aluminum hydrides is the compound of general formula (IV) 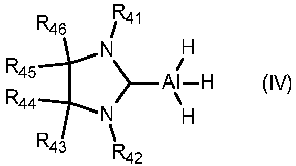 wherein R₄₁ to R₄₆ are independent of each other hydrogen, an alkyl group, an alkenyl group, an aryl group, or a silyl group. Preferably, R₄₃ to R₄₆ are hydrogen.

Another preferred example for carbene coordinated aluminum hydrides is the compound of general formula (V) 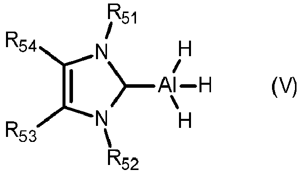 wherein R₅₁ to R₅₄ are independent of each other hydrogen, an alkyl group, an alkenyl group, an aryl group, or a silyl group. Preferably, R₅₃ and R₅₄ are hydrogen.

Further preferred examples for aluminum hydrides are the compounds of general formula (VIa), (VIb), (VIc), (VId), (VIe), (VIf), (VIg). 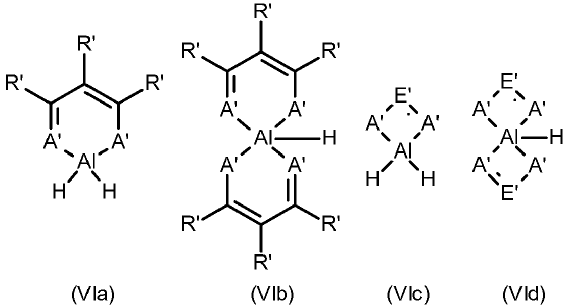 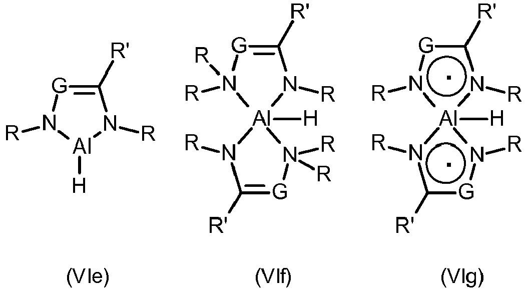
wherein A' is NR or O,
E' is CR", CNR"₂, N, PR"₂, or SOR",
G is CR' or N,
R is an alkyl group, an alkenyl group, an aryl group, or a silyl group and
R' and R" are hydrogen, an alkyl group, an alkenyl group, an aryl group, or a silyl group.

Further preferred examples for aluminum hydrides are the compounds of general formula (VIIa), (VIIb), (VIIc). 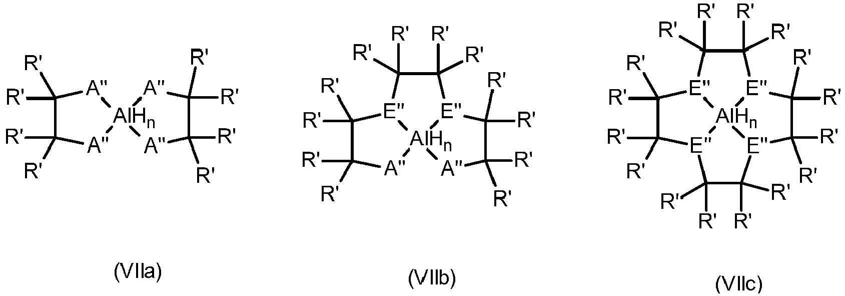
wherein A" is NR, NR₂, PR, PR₂, O, OR, S, or SR,
E" is N, NR, P, PR, O or S,
n is 1, 2, or 3,
R is an alkyl group, an alkenyl group, an aryl group, or a silyl group and
R' is hydrogen, an alkyl group, an alkenyl group, an aryl group, or a silyl group, and
A", E", and n are chosen such that the compound of general formula (VIIa), (VIIb), or (VIIc) is electronically neutral.

An alkyl group can be linear or branched. Examples for a linear alkyl group are methyl, ethyl, n-propyl, n-butyl, n-pentyl, n-hexyl, n-heptyl, n-octyl, n-nonyl, n-decyl. Examples for a branched alkyl group are iso-propyl, iso-butyl, sec-butyl, tert-butyl, 2-methyl-pentyl, neo-pentyl, 2-ethylhexyl, cyclopropyl, cyclohexyl, indanyl, norbornyl. Preferably, the alkyl group is a C₁ to C₈ alkyl group, more preferably a C₁ to C₆ alkyl group, in particular a C₁ to C₄ alkyl group, such as methyl, ethyl, iso-propyl or tert-butyl.

An alkenyl group contains at least one carbon-carbon double bond. The double bond can include the carbon atom with which R is bound to the rest of the molecule, or it can be placed further away from the place where R is bound to the rest of the molecule. Alkenyl groups can be linear or branched. Examples for linear alkenyl groups in which the double bond includes the carbon atom with which R is bound to the rest of the molecule include 1-ethenyl, 1-propenyl, 1-n-butenyl, 1-n-pentenyl, 1-n-hexenyl, 1-n-heptenyl, 1-n-octenyl. Examples for linear alkenyl groups in which the double bond is placed further away from the place where R is bound to the rest of the molecule include 1-n-propen-3-yl, 2-buten-1-yl, 1-buten-3-yl, 1-buten-4-yl, 1-hexen-6-yl. Examples for branched alkenyl groups in which the double bond includes the carbon atom with which R is bound to the rest of the molecule include 1-propen-2-yl, 1-n-buten-2-yl, 2-buten-2-yl, cyclopenten-1-yl, cyclohexen-1-yl. Examples for branched alkenyl groups in which the double bond is placed further away from the place where R is bound to the rest of the molecule include 2-methyl-1-buten-4-yl, cyclopenten-3-yl, cyclohexene-3-yl. Examples for an alkenyl group with more than one double bonds include 1,3-butadien-1-yl, 1,3-butadien-2-yl, cylopentadien-5-yl.

Aryl groups include aromatic hydrocarbons such as phenyl, naphthalyl, anthrancenyl, phenanthrenyl groups and heteroaromatic groups such as pyrryl, furanyl, thienyl, pyridinyl, quinoyl, benzofuryl, benzothiophenyl, thienothienyl. Several of these groups or combinations of these groups are also possible like biphenyl, thienophenyl or furanylthienyl. Aryl groups can be substituted for example by halogens like fluoride, chloride, bromide, iodide; by pseudohalogens like cyanide, cyanate, thiocyanate; by alcohols; alkyl chains or alkoxy chains. Aromatic hydrocarbons are preferred, phenyl is more preferred.

A silyl group is a silicon atom with typically three substituents. Preferably a silyl group has the formula SiX₃, wherein X is independent of each other hydrogen, an alkyl group, an aryl group or a silyl group. It is possible that all three X are the same or that two A are the same and the remaining X is different or that all three X are different to each other, preferably all X are the same. Alkyl and aryl groups are as described above. Examples for siliyl groups include SiH₃, methylsilyl, trimethylsilyl, triethylsilyl, tri-n-propylsilyl, tri-iso-propylsilyl, tricyclohexylsilyl, dimethyl-tert-butylsilyl, dimethylcyclohexylsilyl, methyl-di-iso-propylsilyl, triphenylsilyl, phenylsilyl, di-methylphenylsilyl, pentamethyldisilyl.

Preferably, R₁₁, R₂₁ and/or R₂₂ bears no hydrogen atom in the 1-position, i.e. R₁₁, R₂₁ and/or R₂₂ bears no hydrogen atom which is bond to the atom which is bond to the nitrogen atom. Examples are alkyl group bearing two alkyl side groups in the 1-position, i.e. 1,1-dialkylalkyl, such as tert-butyl, 1,1-dimethylpropyl; alkyl groups with two halogens in the 1-position such as trifluoromethyl, trichloromethyl, 1,1-difluoroethyl; trialkylsilyl groups such as trimethylsilyl, triethylsilyl, dimethyl-tert-butylsilyl; aryl groups, in particular phenyl or alkyl-substituted phenyl such as 2,6-diisopropylphenyl, 2,4,6-triisopropylphenyl. Alkyl groups bearing no hydrogen atom in the 1-position are particularly preferred.

The solid substrate can be brought in contact with the aluminum hydride derivative. Preferably, the solid substrate is placed in an apparatus suitable for evacuation with inlets through which aluminum hydride derivative is introduced into the apparatus at a certain dose. This dose can be at least 5 mbar·s, more preferably at least 8 mbar·s, in particular at least 10 mbar·s. The dose is as commonly used in the art the partial pressure of the aluminum hydride derivative at the place of deposition times the time the substrate is exposed to the aluminum hydride derivative. It is usually preferable to increase the partial pressure of the aluminum hydride derivative to achieve the dose, preferably the partial pressure of the aluminum hydride derivative is at least 1 mbar, more preferably at least 5 mbar, in particular at least 10 mbar. The partial pressure can be increased by choosing a more volatile aluminum hydride derivative, and/or by increasing the temperature at the site of evaporation or by keeping the aluminum hydride derivative at an elevated temperature for an extended amount of time.

The aluminum hydride derivative preferably has a molecular weight of not more than 1000 g/mol, more preferably not more than 800 g/mol, even more preferably not more than 600 g/mol, in particular not more than 500 g/mol. The aluminum hydride derivative preferably has a decomposition temperature of at least 80 °C, more preferably at least 100 °C, in particular at least 120 °C, such as at least 150 °C. Often, the decomposition temperature is not more than 250 °C. The aluminum hydride derivative has a high vapor pressure. Preferably, the vapor pressure is at least 1 mbar at a temperature of 200 °C, more preferably 150 °C, in particular 120 °C. Usually, the temperature at which the vapor pressure is 1 mbar is at least 50 °C.

According to the present invention, the aluminum halide partial vapor pressure is 0.001 to 5 mbar, preferably 0.01 to 3 mbar, more preferably 0.05 to 2 mbar, in particular 0.1 to 1 mbar, for example 0.5 to 0.8 mbar or 0.2 to 0.4 mbar. It has surprisingly found out that such a partial vapor pressure of aluminum halide leads to continuous thin films as it seems to reduce island growth. Without being bound by any theory, it is believed that this is because the oxygen content in the apparatus is reduced. Alternatively or additionally, a little bit of reaction between the aluminum halide and the aluminum hydride derivative in the gas phase and subsequent deposition may form more nucleation sites leading to more homogeneous films.

An aluminum halide includes aluminum fluoride, aluminum chloride, aluminum bromide, and aluminum iodide, preferably aluminum chloride or aluminum bromide, in particular aluminum chloride.

Preferably, the process further contains a step of bringing the solid substrate in contact with an aluminum halide in the gaseous state before bringing the solid substrate in contact with the aluminum hydride derivative. Hence, preferably the process comprises the steps
(a) bringing the solid substrate in contact with an aluminum halide in the gaseous state and
(b) bringing the solid substrate in contact with the aluminum hydride derivative,
wherein the partial vapor pressure of an aluminum halide in step (b) is 0.01 to 5 mbar.

The aluminum halide partial vapor can be adjusted in various ways. Usually, aluminum halide is introduced simultaneously to the aluminum hydride derivative. The aluminum halide can be introduced continuously or in a pulsed way. However, if the process contains the additional step (a) described above, it is possible to use only as much aluminum halide in step (a) as can react with the surface leaving no more aluminum halide for step (b) as described above. Preferably however, excess aluminum halide vapor is removed between step (a) and step (b). This can be achieved by purging with an inert gas, for example nitrogen or argon. Purging can take from a second to a couple of minutes, preferably 5 to 30 s. Alternatively or additionally, a vacuum can be applied, for example down to pressures of 10⁻⁹ to 10⁻¹ mbar, preferably 10⁻⁶ to 10⁻³ mbar. The vacuum can be applied for a second to several minutes, preferably 5 to 30 s. Preferably, the partial vapor pressure of the aluminum halide does not fall below 0.001 mbar during steps (a) and (b), more preferably it does not fall below 0.01 mbar, even more preferably not below 0.05 mbar, in particular not below 0.1 mbar. Even more preferably, the partial vapor pressure of the aluminum halide does not fall below the just mentioned values during and between steps (a) and (b).

Both the aluminum halide and the aluminum hydride derivative are used at high purity to achieve the best results. High purity means that the substance used contains at least 90 wt.-% aluminum halide or aluminum hydride derivative, preferably at least 95 wt.-%, more preferably at least 98 wt.-%, in particular at least 99 wt.-%. The purity can be determined by elemental analysis according to DIN 51721 (Prüfung fester Brennstoffe - Bestimmung des Gehaltes an Kohlenstoff und Wasserstoff - Verfahren nach Radmacher-Hoverath, August 2001).

The aluminum halide compound or the aluminum hydride derivative can be deposited or brought in contact with the solid substrate from the gaseous state. They can be brought into the gaseous state for example by heating them to elevated temperatures. In any case a temperature below the decomposition temperature of the aluminum halide or the aluminum hydride derivative has to be chosen. In this context, the oxidation of the aluminum hydride derivative is not regarded as decomposition. A decomposition is a reaction in which the aluminum halide or the aluminum hydride derivative is converted to an undefined variety of different compounds. Preferably, the heating temperature ranges from 0 °C to 300 °C, more preferably from 10 °C to 250 °C, even more preferably from 20 °C to 200 °C, in particular from 30 °C to 150 °C.

Another way of bringing the aluminum halide or the aluminum hydride derivative into the gaseous state is direct liquid injection (DLI) as described for example in US 2009 / 0 226 612 A1. In this method the aluminum halide or the aluminum hydride derivative is typically dissolved in a solvent and sprayed in a carrier gas or vacuum. If the vapor pressure of aluminum halide or the aluminum hydride derivative and the temperature are sufficiently high and the pressure is sufficiently low the aluminum halide or the aluminum hydride derivative is brought into the gaseous state. Various solvents can be used provided that the aluminum halide or the aluminum hydride derivative shows sufficient solubility in that solvent such as at least 1 g/l, preferably at least 10 g/l, more preferably at least 100 g/l. Examples for these solvents are coordinating solvents such as tetrahydrofuran, dioxane, diethoxyethane, pyridine or non-coordinating solvents such as hexane, heptane, benzene, toluene, or xylene. Solvent mixtures are also suitable.

Alternatively, the aluminum halide or the aluminum hydride derivative can be brought into the gaseous state by direct liquid evaporation (DLE) as described for example by J. Yang et al. (Journal of Materials Chemistry, 2015). In this method, the aluminum halide or the aluminum hydride derivative is mixed with a solvent, for example a hydrocarbon such as tetradecane, and heated below the boiling point of the solvent. By evaporation of the solvent, the aluminum halide or the aluminum hydride derivative is brought into the gaseous state. This method has the advantage that no particulate contaminants are formed on the surface.

It is preferred to bring the aluminum halide or the aluminum hydride derivative into the gaseous state at decreased pressure. In this way, the process can usually be performed at lower heating temperatures leading to decreased decomposition of the aluminum halide or the aluminum hydride derivative. It is also possible to use increased pressure to push the aluminum halide or the aluminum hydride derivative in the gaseous state towards the solid substrate. Often, an inert gas, such as nitrogen or argon, is used as carrier gas for this purpose. Preferably, the pressure is 1 bar to 10⁻² mbar, in particular 100 to 0.1 mbar.

When the solid substrate is brought in contact with the aluminum hydride derivative and/or the aluminum halide, usually aluminum deposition occurs. Generally, the deposition process can be conducted in two different ways: either the substrate is heated above or below the decomposition temperature of the aluminum hydride derivative and/or the aluminum halide. If the substrate is heated above the decomposition temperature of the aluminum hydride derivative and/or the aluminum halide, it continuously decomposes on the surface of the solid substrate as long as more aluminum hydride derivative and/or aluminum halide in the gaseous state reaches the surface of the solid substrate. This process is typically called chemical vapor deposition (CVD). Typically, the solid substrate is heated to a temperature in the range of 300 to 1000 °C, preferably in the range of 350 to 600 °C.

Alternatively, the substrate is below the decomposition temperature of the aluminum hydride derivative and/or the aluminum halide. Typically, the solid substrate is at a temperature equal to or slightly above the temperature of the place where the aluminum hydride derivative and/or the aluminum halide is brought into the gaseous state, often at room temperature or only slightly above. Preferably, the temperature of the substrate is 5 °C to 40 °C higher than the place where the aluminum hydride derivative and/or the aluminum halide is brought into the gaseous state, for example 20 °C. Preferably, the temperature of the substrate is from room temperature to 400 °C, more preferably from 100 to 300 °C, such as 150 to 220 °C.

The deposition of the aluminum hydride derivative and/or the aluminum halide onto the solid substrate is either a physisorption or a chemisorption process. Preferably, the aluminum hydride derivative and/or the aluminum halide is chemisorbed on the solid substrate. One can determine if the aluminum hydride derivative and/or the aluminum halide chemisorbs to the solid substrate by exposing a quartz microbalance with a quartz crystal having the surface of the substrate in question to the aluminum hydride derivative and/or the aluminum halide in the gaseous state. The mass increase is recorded by the eigen frequency of the quartz crystal. Upon evacuation of the chamber in which the quartz crystal is placed the mass should not decrease to the initial mass, but up to a monolayer of the residual aluminum hydride derivative and/or the aluminum halide remains if chemisorption has taken place. In most cases where chemisorption of the aluminum halide to the solid substrate occurs, the x-ray photoelectron spectroscopy (XPS) signal (ISO 13424 EN - Surface chemical analysis - X-ray photoelectron spectroscopy - Reporting of results of thin-film analysis; October 2013) of M changes due to the bond formation to the substrate.

If the temperature of the substrate in the process according to the present invention is kept below the decomposition temperature of the aluminum hydride derivative and/or the aluminum halide, typically a monolayer is deposited on the solid substrate. Once a molecule of the aluminum hydride derivative and/or the aluminum halide is deposited on the solid substrate further deposition on top of it usually becomes less likely. Thus, the deposition of the aluminum halide on the solid substrate preferably represents a self-limiting process step. The typical layer thickness of a self-limiting deposition processes step is from 0.01 to 1 nm, preferably from 0.02 to 0.5 nm, more preferably from 0.03 to 0.4 nm, in particular from 0.05 to 0.2 nm. The layer thickness is typically measured by ellipsometry as described in PAS 1022 DE (Referenzverfahren zur Bestimmung von optischen und dielektrischen Materialeigenschaften sowie der Schichtdicke dünner Schichten mittels Ellipsometrie; February 2004).

A deposition process comprising a self-limiting process step and a subsequent self-limiting reaction is often referred to as atomic layer deposition (ALD). Equivalent expressions are molecular layer deposition (MLD) or atomic layer epitaxy (ALE). Hence, the metal deposition in the process according to the present invention is preferably an ALD process. The ALD process is described in detail by George (Chemical Reviews 110 (2010), 111-131).

Preferably, steps (a) and (b) are consecutively performed at least twice, more preferably at least 10 times, in particular at least 50 times. Usually, steps (a) and (b) are performed not more than 1000 times.

The solid substrate can be brought in contact with the aluminum halide or the aluminum hydride derivative for milliseconds to several minutes, preferably from 0.1 second to 1 minute, in particular from 1 to 10 seconds.

The process according to the present invention yields an aluminum-containing film, in particular an aluminum film. A film can be only one monolayer of a metal or be thicker such as 0.1 nm to 1 µm, preferably 0.5 to 50 nm. A film can contain defects like holes. These defects, however, generally constitute less than half of the surface area covered by the film. The film preferably has a very uniform film thickness which means that the film thickness at different places on the substrate varies very little, usually less than 10 %, preferably less than 5 %. Furthermore, the film is preferably a conformal film on the surface of the substrate. Suitable methods to determine the film thickness and uniformity are XPS or ellipsometry.

The film obtained by the process according to the present invention can be used in an electronic element. Electronic elements can have structural features of various sizes, for example from 100 nm to 100 µm. The process for forming the films for the electronic elements is particularly well suited for very fine structures. Therefore, electronic elements with sizes below 1 µm are preferred. Examples for electronic elements are field-effect transistors (FET), solar cells, light emitting diodes, sensors, or capacitors. In optical devices such as light emitting diodes or light sensors the film obtained by the process according to the present invention serves to increase the reflective index of the layer which reflects light.

Preferred electronic elements are transistors. Preferably the film acts as chemical barrier metal in a transistor. A chemical barrier metal is a material reduces diffusion of adjacent layers while maintaining electrical connectivity.

## Claims

1. Process for preparing an aluminum-containing film comprising bringing a solid substrate in contact with an aluminum hydride derivative in the gaseous state while the partial vapor pressure of an aluminum halide is 0.001 to 5 mbar.

2. The process according to claim 1, wherein the aluminum halide partial vapor pressure is 0.01 to 1 mbar.

3. The process according to claim 1 or 2, wherein the aluminum hydride derivative is an alkyl aluminum hydride, an amine coordinated aluminum hydride, or a carbene coordinated aluminum hydride.

4. The process according to claim 1 or 2, wherein the aluminum hydride derivative is a compound of general formula (Ia) or (Ib) 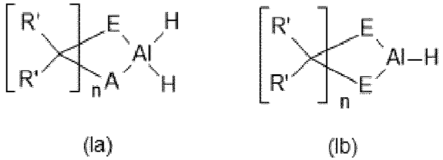
wherein A is NR₂ or OR with R being an alkyl group, an alkenyl group, an aryl group, or a silyl group,
E is NR or O,
n is 0, 1 or 2, m is 0, 1 or 2, and
R' is hydrogen, an alkyl group, an alkenyl group, an aryl group, or a silyl group.

5. The process according to claim 1 or 2, wherein the aluminum hydride derivative is a compound of general formula (IIIa), (IIIb), (IIIc), or (IIId) 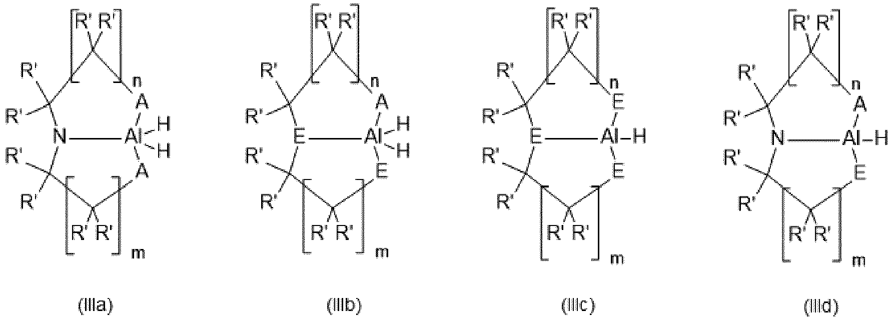
wherein A is NR₂ or OR with R being an alkyl group, an alkenyl group, an aryl group, or a silyl group,
E is NR or O,
n is 0, 1 or 2, m is 0, 1 or 2, and
R' is hydrogen, an alkyl group, an alkenyl group, an aryl group, or a silyl group.

6. The process according to claim 1 or 2, wherein the aluminum hydride derivative is a compound of general formula (IV) or (V) 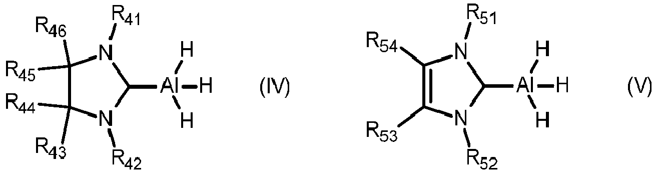 wherein R₄₁ to R₄₆ and R₅₁ to R₅₄ are independent of each other hydrogen, an alkyl group, an alkenyl group, an aryl group, or a silyl group.

7. The process according to claim 1 or 2, wherein the aluminum hydride derivative is a compound of general formula (Vila), (Vllb) or (VIIc) 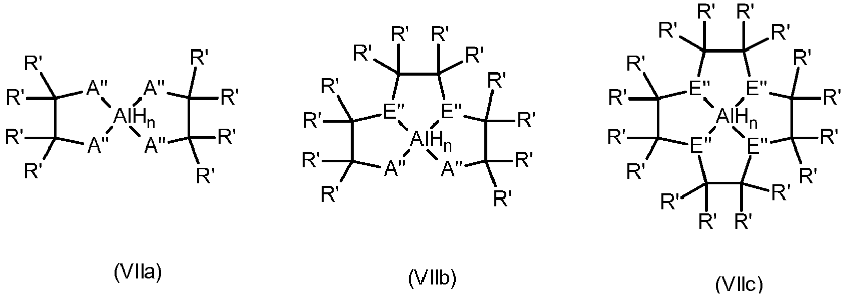
wherein A" is NR, NR₂, PR, PR₂, O, OR, S, or SR,
E" is N, NR, P, PR, O or S,
n is 1, 2, or 3,
R is an alkyl group, an alkenyl group, an aryl group, or a silyl group and
R' is hydrogen, an alkyl group, an alkenyl group, an aryl group, or a silyl group, and
A", E", and n are chosen such that the compound of general formula (Vila), (Vllb), or (VIIc) is electronically neutral.

8. The process according to any of the claims 1 to 7, wherein the aluminum hydride derivative has a molecular weight of not more than 600 g/mol.

9. The process according to any of the claims 1 to 8, wherein the aluminum hydride derivative has a vapor pressure at least 1 mbar at a temperature of 200 °C.

10. The process according to any of the claims 1 to 9, wherein the aluminum halide is aluminum chloride or aluminum bromide.

11. The process according to any of the claims 1 to 10, wherein the process further contains a step of bringing the solid substrate in contact with an aluminum halide in the gaseous state before bringing the solid substrate in contact with the aluminum hydride derivative.

12. The process according to claim 11, wherein after brining the solid substrate in contact with the aluminum halide and before bringing it in contact with the aluminum hydride derivative, excess aluminum halide is removed and during bringing it in contact with the aluminum hydride derivative additional aluminum halide is brought towards the solid substrate.

13. The process according to claim 12, wherein the aluminum halide is brought to the solid substrate in a pulsed way.

14. The process according to any of the claims 1 to 13, wherein step (a) and (b) are consecutively performed at least twice.

15. The process according to any of the claims 1 to 14, wherein the temperature does not exceed 350 °C.
